# EUROPÄISCHE PATENTANMELDUNG

(11) **EP 4 160 229 A1**
(43) Veröffentlichungstag der Anmeldung: **05.04.2023**
(21) Anmeldenummer: 21200255.4
(22) Anmeldetag: 30.09.2021
(51) Int. Cl.: G01R 31/08, G05B 23/02, G06K 9/62, G06N 3/02

(54) **VERFAHREN ZUM ÜBERWACHEN EINER MASCHINE, COMPUTERPROGRAMMPRODUKT UND ANORDNUNG**

(71) Anmelder: Siemens Aktiengesellschaft, 80333 München (DE)
(72) Erfinder: Al Hage Ali, Ali, 91052 Erlangen (DE); Bögler, Marco, 91083 Baiersdorf (DE); Wolf Pozzo, Christian Andreas, 90513 Zirndorf (DE)
(74) Vertreter: Siemens Patent Attorneys

(57) **Zusammenfassung**

Verfahren zum Überwachen einer Maschine, Computerprogrammprodukt und Anordnung

Die Erfindung betrifft ein Verfahren (PRC) zum Überwachen des Betriebs einer Maschine (MCH), insbesondere eines Motors (ENG) oder elektrisch angetriebenen Motors (EEG). Die Erfindung schlägt zu Verbesserung der Überwachung ein derartiges Verfahren vor umfassend folgende Schritte:
c) Trainingsphase (TPH):
i. bereitstellen von Trainingsdaten (TDT) umfassend Zustandsgrößen (PHC) mehrerer Betriebspunkte (OPP) der Maschine (MCH),
ii. erkennen und zusammenfassen von Betriebspunkten (OPP) der Trainingsdaten (TDT) mittels Clusterings (CLS) zu Betriebspunktclustern (OCL),
iii. trainieren eines Klassifikators (CLF), der Betriebspunkte (OPP) zu den erkannten Betriebspunktclustern (OCL) zuordnet,
iv. trainieren eines Anomalieerkennungsmodells (ARM) zur Betriebsanomalieerkennung,

d) Anwendungsphase.
i. aufnehmen von Betriebsdaten (OPD) umfassend Zustandsgrößen (PHC) von Betriebspunkten (OPP) der Maschine (MCH) in einem Betriebszustand,
ii. zuordnen der Betriebsdaten (OPD) zu den Betriebspunktclustern (OCL) mittels des Klassifikators (CLF),

erkennen von Betriebsanomalien mittels des Anomalieerkennungsmodells (ARM).

## Beschreibung

Die Erfindung betrifft ein Verfahren zum Überwachen des Betriebs einer Maschine, insbesondere eines Motors oder elektrisch angetriebenen Motors.

Während des Betriebs von Maschinen, beispielsweise von Antriebssystemen können Fehler und Anomalien auftreten. Diese Probleme können durch die Mechanik verursacht werden, aber auch elektrische Gründe haben und betreffen sowohl den Motor als auch die Applikation. Werden diese Fehler und Veränderungen nicht frühzeitig erkannt, führt dies zu erhöhten Ausfallzeiten und einem zusätzlichen und erhöhten Wartungsaufwand. Die Überwachung von Motorapplikationen ist daher von entscheidender Bedeutung für eine effiziente, kostengünstige und flexible Produktion. Diese ist jedoch mit technischen Herausforderungen verbunden:
1) Viele Maschinen, zum Beispiel Motorapplikationen (wie Pumpen und Lüfter) werden Umrichter getrieben und haben dadurch unterschiedliche Betriebspunkte. Bei der Zustandsüberwachung solcher Applikationen werden typischerweise die unterschiedlichen Betriebspunkte nicht explizit berücksichtigt bzw. eine betriebspunktabhängige Überwachung findet nicht statt. Dies führt dazu, dass Fehler erst zu spät oder gar nicht detektiert werden. Eine Eingrenzung des Fehlers ist ebenfalls nicht möglich. Zudem kann die Vibration je nach Betriebspunkt stark variieren. Eine Überwachung des allgemeinen Vibrationslevels über alle Betriebspunkte hinweg, kann die unterschiedlichen Änderungen innerhalb eines Betriebspunkts möglicherweise nicht erkennen und somit Anfangsschäden nicht detektieren.
2) Außerdem werden bei der Zustandsüberwachung die Rahmenbedingungen des Systems nicht berücksichtigt, z.B. die Applikation, die Störeinflüsse aus der Umgebung, die Installation, etc. Diese können die Robustheit und Zuverlässigkeit der Zustandsüberwachung beeinflussen.

Motorapplikationen (Pumpen, Lüfter) werden durch die manuelle Konfiguration von normbasierten Grenzen überwacht. Eine Unterscheidung nach Betriebspunkten ist heute nicht vorhanden. Dabei werden auch die Rahmenbedingungen nicht berücksichtigt.

Ausgehend von den Problemen und Nachteilen des Standes der Technik hat es sich die Erfindung zur Aufgabe gemacht, die Überwachung von derartigen Maschinen, insbesondere von Motoren zu verbessern und damit Maschinenschäden infolge von ungünstigen Betriebsbedingungen zu verhindern.

Die Erfindung schlägt zu Verbesserung der Überwachung ein Verfahren der eingangs definierter Art vor, umfassend folgende Schritte:
a) Trainingsphase:
   i. Bereitstellen von Trainingsdaten umfassend Zustandsgrößen mehrerer Betriebspunkte der Maschine,
   ii. Erkennen und Zusammenfassen von Betriebspunkten der Trainingsdaten mittels Clusterings zu Betriebspunktclustern,
   iii. Trainieren eines Klassifikators, der Betriebspunkte zu den erkannten Betriebspunktclustern zuordnet,
   iv. Trainieren mindestens eines Anomalieerkennungsmodells zur Betriebsanomalieerkennung,
b) Anwendungsphase.
   i. Aufnehmen von Betriebsdaten umfassend Zustandsgrößen von Betriebspunkten der Maschine in einem Betriebszustand,
   ii. Zuordnen der Betriebsdaten zu den Betriebspunktclustern mittels des Klassifikators,
   iii. Erkennen von Betriebsanomalien mittels des mindestens einen Anomalieerkennungsmodells.

Eine Zustandsgröße ist im Zusammenhang der Erfindung eine makroskopische physikalische Größe. Mittels Zustandsgrößen kann der Zustand eines physikalischen Systems beschrieben werden. Beispielsweise handelt es sich um z.B. thermodynamisch Druck, Temperatur oder auch Größen anderer naturwissenschaftlicher Disziplinen, wie beispielsweise Drehzahl, Kraft, Drehmoment, Spannung, Strom, Leistung, Wirkungsgrad oder Lautstärke.

Eine vorteilhafte Variante der Erfindung sieht vor, dass das mindestens eine Anomalieerkennungsmodell ein unsupervised model ist.

Unter einem unsupervised model (Siehe hierzu auch https://de.wikipedia.org/wiki/Un%C3%BCberwachtes_Lernen) versteht die Erfindung ein Modell - also ein vereinfachtes Abbild der Wirklichkeit - das ausgebildet ist, maschinell zu lernen (machine learning), ohne dass bestimmte Zielwerte des Lernvorgangs vorab festgesetzt sind. Hierbei erkennt das unsupervised model, in den Eingabedaten Muster, die vom strukturlosen Rauschen abweichen. Eine bevorzugte Möglichkeit der Implementierung des unsupervised model besteht in der Benutzung von Algorithmen künstlicher neuronaler Netze. Diese orientieren sich an der Ähnlichkeit von Eingabewerten und adaptieren sich entsprechend. Hierbei ist es möglich ein Clustering (Segmentierung oder Gruppierung) automatisch zu erstellen.

Eine vorteilhafte Variante der Erfindung sieht vor, dass Betriebspunkte Messwerte von mindestens einem der Arten: Vibration, Temperatur, Drehmoment, zugeführte Leistung, abgegebene Leistung, Wirkungsgrad (z.B. elektrischer oder thermischer), Energieverbrauch, elektrischer Strom, elektrische Spannung, Frequenz Versorgungsspannung (bei Umrichter-geführten Elektromotoren) umfassen.

Eine vorteilhafte Variante der Erfindung sieht vor, dass die Trainingsdaten mehrere Betriebspunkte und/oder historische Daten und/oder Referenzmessungen und/oder Fingerprints umfassen. Diese Trainingsdaten können aus derselben Maschine oder einer Gruppe von gleichen Maschinen stammen. Es ist auch möglich, simulierte Daten oder Daten von ähnlichen Maschinen zu verwenden. Hierbei kann es zweckmäßig sein, dass das Verfahren weitere Schritte umfasst, insbesondere:
- vorverarbeiten der Trainingsdaten und oder Betriebsdaten mittels Datenbereinigung und/oder Datenskalierung, insbesondere unter Verwendung weiterer Datenquellen und/oder Daten aus einem Digitalen Zwilling und/oder Maschinennennwerten.

Eine vorteilhafte Variante der Erfindung sieht vor, dass das mindestens eine Anomalieerkennungsmodell einen Anomalie-Kennwert (oder Anomalie-score) berechnet, dessen Wert den Schweregrad der Anomalie beschreibt, wobei eine Anomalie oder ein Anomalie-Typus erkannt wird, wenn der Anomalie-Kennwert einen vorbestimmten Schwellwert überschreitet. Hierbei ist es gemäß einer vorteilhaften Variante der Erfindung sinnvoll, wenn die Anomalie oder der Anomalie-Typus als einen fehlerhaften Betriebspunkt erkennt, insbesondere, wenn das Anomalieerkennungsmodell eingrenzt, bei welchem Betriebspunkt die Anomalie sichtbar ist oder auftritt. Es kann auch zweckmäßig sein, anhand des Anomalie-Kennwerts und mehreren Schwellwerten einem Betriebszustand jeweils einen von verschieden Typen von Anomalien zuzuordnen, wobei jeder Typ einer Anomalie einen eigenen Schwellwert aufweisen kann. Beispielsweise kann ein niedriger Anomalie-Kennwert einen Normalzustand anzeigen, ein mittlerer die Notwendigkeit einer bestimmten bevorstehenden Wartungsnotwendigkeit und ein höherer die Notwendigkeit, die Maschine abzuschalten.

Eine vorteilhafte Variante der Erfindung sieht vor, dass das Verfahren weitere Schritte umfasst:
- Anzeigen des Anomalie-Kennwert und/oder auf dem Anomalie-Kennwert basierende Empfehlungen zum Betrieb der Maschine und/oder
- Steuern, insbesondere automatisches Steuern der Maschine, so dass sich der gegenwärtige Betriebspunkt der Maschine ändert.

Grundsätzlich kann sich eine Anordnung nach der Erfindung mit einem oder mehreren ggf. unterschiedlichen Human-Machine-Interfaces in Verbindung befinden. Hierbei ist es zweckmäßig, wenn es unter diesen Human-Machine-Interfaces wenigstens ein Display vorgesehen ist, so dass Anomalie-Kennwerte und/oder auf Anomalie-Kennwerten basierende Empfehlungen zum Betrieb der Maschine angezeigt werden können.

Eine vorteilhafte Variante der Erfindung sieht vor, dass der Klassifikator als ein supervised model (siehe auch https://de.wikipedia.org/wiki/%C3%9Cberwachtes_Lernen), insbesondere arbeitend nach dem Verfahren nearest-centroid oder random-forest oder als neuronales Netz ausgebildet ist.

Eine vorteilhafte Variante der Erfindung sieht vor, dass den einzelnen Betriebspunktclustern jeweils ein gesondertes Anomalieerkennungsmodell zugeordnet ist, insbesondere wobei jedem Betriebspunktcluster jeweils ein gesondertes Anomalieerkennungsmodell zugeordnet ist. Diese Architektur ermöglicht eine besonders effiziente Erkennung der Anomalien, weil die Anomalien nach besonderer Erkenntnis der Erfindung in der Regel betriebspunktclusterspezifisch auftreten können. Die Klassifizierung in Betriebspunktcluster einerseits und die Modellierung der Anomalieerkennung spezifisch für diese Cluster macht die einzelnen Anomalieerkennungsmodelle schneller und effizienter als bei einer Anomalieerkennung ohne vorherige Clusterbildung. Die gesonderte Zuordnung eines Anomalieerkennungsmodell zu jeweils einem Betriebspunktcluster betrifft sowohl die Trainingsphase als auch die Anwendungs-phase. Das bedeutet, dass bevorzugt die einzelnen Anomalieerkennungsmodelle betriebspunktclusterspezifisch in der Trainingsphase trainiert werden und bevorzugt anschließend in der Anomalieerkennungsmodelle betriebspunktclusterspezifisch in der Anwendungsphase zur Anomalieerkennung angewendet werden.

Weiterhin betrifft die Erfindung ein Computerprogrammprodukt zur Durchführung eines Verfahrens gemäß der Beschreibung der Erfindung oder von Ausführungsbeispielen oder nach mindestens einem oder einer Kombination der Ansprüche mittels mindestens eines Computers. Das Computerprogrammprodukt kann hierbei auf einem Datenträger gespeichert sein und mittels dieses Datenträgers und/oder mittels Downloads von dem Datenträger transportierbar, veräußerbar oder anderweitig nutzbar sein.

Weiterhin betrifft die Erfindung eine Anordnung, insbesondere umfassend mindestens einen Computer zur Durchführung eines Verfahrens nach mindestens einem oder einer Kombination der Ansprüche mittels mindestens eines Computers, wobei die Anordnung den mindestens einen zur Durchführung des Verfahrens vorbereiteten Computer umfasst. Hierzu ist der Computer bevorzugt mit einem Computerprogrammprodukt nach der Erfindung präpariert, das Verfahren auszuführen. Bei dem Computer kann es sich auch um ein Computernetzwerk handeln, wobei die Anwendung des Verfahrens mittels mehrerer Computer erfolgen kann, die parallel oder gemeinsam das Verfahren ausführen. Alternativ oder zusätzlich kann der Computer als Edge-Gerät, bevorzugt angeordnet in dem räumlichen Umfeld oder in der bevorzugt unmittelbaren Umgebung der Maschine oder angebracht an der Maschine, ausgebildet sein. Die Anordnung kann bevorzugt auch die Maschine, insbesondere einen Motor, zum Beispiel einen elektrischen Motor, insbesondere umfassend einen Umrichter, umfassen.

Nach einer möglichen beispielhaften Ausbildung der Erfindung erfolgt die Überwachung einer Maschine, insbesondere eines Motors und dessen Applikationsdaten betriebspunktspezifisch. Die unterschiedlichen Betriebspunkte werden hierbei mittels Clustering-Algorithmen automatisch detektiert und gruppiert. Für jeden Betriebspunkt wird dann ein Unsupervised Modell zur Anomalieerkennung trainiert. Innerhalb jedes detektierten Betriebspunktes können damit verschiedene Größen überwacht werden (z.B. Vibration, Temperatur,..).
Außerdem wird auf Basis der Clustering Ergebnisse ein Supervised Klassifier erstellt, um im Betrieb die Betriebspunkte zu klassifizieren. Die Basis der Erstellung bilden bevorzugt historische Daten in Form von Fingerprints/Referenzmessungen.

Zu Beginn der Trainingsphase der möglichen beispielhaften Ausbildung der Erfindung sollte ein Fingerprint erstellt werden. Der Fingerprint ist hierbei ein Satz von Messungen von Sensoren (z.B. Siemens SIMOTICS CONNECT 400) oder anderen Datenquellen (z.B. Motor Digital Twin) innerhalb eines definierten Zeitbereichs und beschreibt das Referenz- oder Normalverhalten der Motoranwendung. Der Fingerprint enthält hierbei mehrere Betriebspunkte. Dieser bereitgestellte Fingerprint wird vorverarbeitet, d.h. Datenbereinigung und Datenskalierung werden durchgeführt, um einen nutzbaren Standard zu erhalten. Für die Vorverarbeitung können auch andere Datenquellen herangezogen werden, z.B. Motornennwerte, die aus einem Digitalen Zwilling des Motors gewonnen worden sind.

Die vorverarbeiteten Daten werden in dieser beispielhaften Ausbildung der Erfindung dann als Eingabe für den Clustering-Algorithmus verwendet, der auf maschinellem Lernen basiert (hier insbesondere bevorzugt hierarchisches Clustering). Die Clusterung der Betriebspunkte erfolgt bevorzugt hauptsächlich auf der Grundlage von Drehzahl- und Drehmomentmesskurven im Fingerabdruck, es können aber auch andere Werte verwendet werden. Die identifizierten Cluster werden anschließend verwendet, um einen überprüften Klassifikator zu trainieren (z.B. des Typs nearest centroid, random forest oder ausgebildet als neuronales Netz), um neue Daten in einem Cluster zu klassifizieren.
Für jeden Cluster wird ein Modell l zur Erkennung von Anomalien implementiert, das auf einem oder mehreren KPIs (z. B. Vibration, Temperatur usw.) basiert.
Die Modelle werden dann gespeichert, um später auf neue Daten angewendet zu werden.

Eine Anwendungs-Phase einer beispielhaften Ausbildung der Erfindung sieht vor, dass die erstellten Modelle auf neue Messungen angewendet werden, um Anomalien zu erkennen. Zunächst wird eine neue Messung einem bestimmten Betriebspunkt zugeordnet. Dann wird das entsprechende Modell zur Erkennung von Anomalien ausgelöst, das einen Anomalie-Kennwert oder Anomalie-Score berechnet, der den Schweregrad der Anomalie beschreibt. Basierend auf dem Anomalie-Kennwert können spezifische Empfehlungen/Aktivitäten ausgelöst werden.
Diese Modelle erkennen bevorzugt auch während des Betriebs, wenn eine neue Messung nicht zu einem bekannten Betriebspunkt gehört, d.h. die Anwendung läuft in einem neuen Betriebspunkt. In diesem Fall kann das Verfahren vorsehen, dass das betroffene Modell oder die Modelle entweder automatisch neu trainiert werden oder dass eine Empfehlung über ein Human-Machine-Interface gegeben wird, eine Trainingsphase durchzuführen.

Vorteile der Erfindung ergeben sich insbesondere als:
- Früherkennung von Fehlern und Anomalien zur Vermeidung von ungeplanten Stillständen und bessere Planung der Wartungsaktivitäten,
- Effizienz bei der Wartung und Fehlerbehebung durch Eingrenzung der Anomalie nach Betriebspunkt,
- Verlängerung der Produktion durch Wechsel in einem sicheren Betriebspunkt und Vermeidung von kritischen Betriebspunkten,
- Eingrenzung zwischen betriebsbedingten Anomalien (zum Beispiel Blockaden in der Pumpe) und Anomalien, verursacht durch erhöhte Vibrationen (Unwucht, Fehlausrichtung, Lagerschaden, etc.).

Im Folgenden ist die Erfindung anhand eines speziellen Ausführungsbeispiels zur Verdeutlichung näher beschrieben. Es zeigt:

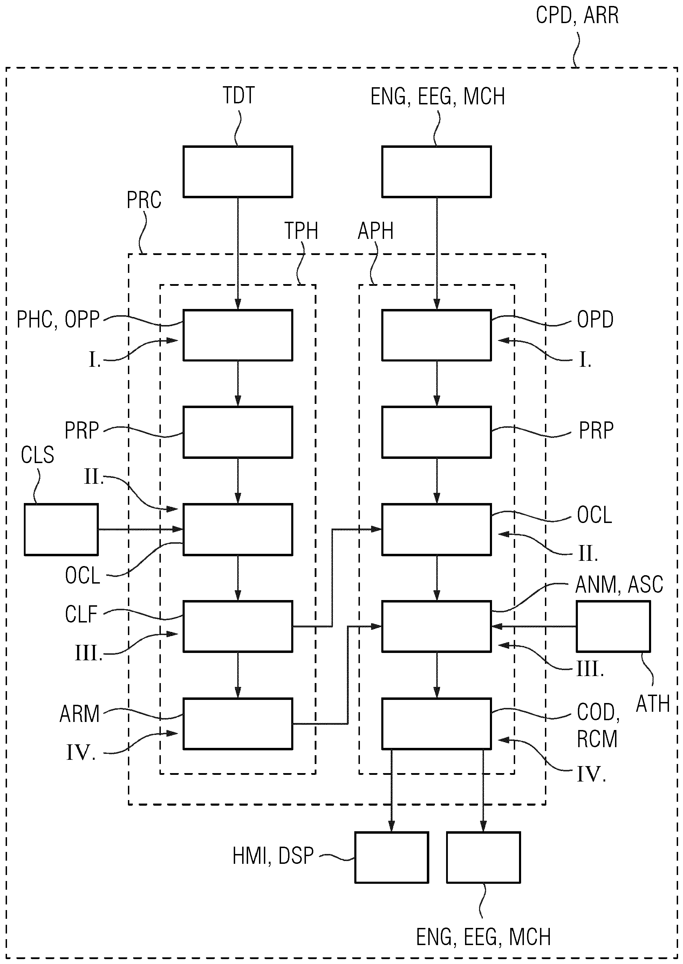

- Figur 1: ein schematisches Ablaufdiagramm des Verfahrens nach der Erfindung.

Figur 1 zeigt ein schematisches Ablaufdiagramm des Verfahrens PRC nach der Erfindung zum Überwachen des Betriebs einer Maschine MCH, vorliegend eines Motors ENG der als elektrisch angetriebener Motors EEG ausgebildet ist. Ein Computerprogrammprodukt CPD nach der Erfindung betrifft das Verfahren PRC und ist in Figur 1 schematisch angedeutet, wobei das Computerprogrammprodukt CPD auf einem Datenspeicher gespeichert ist und bei einer Ausführung auf mindestens einem Computer, den Computer veranlasst, das Verfahren auszuführen. Das Verfahren ist dementsprechend computerimplementiert. Der Computer und ggf. die Maschine (zum Beispiel umfassend einen Motor) entspricht hierbei einer Anordnung ARR nach der Erfindung.

Zunächst wird eine Trainingsphase TPH durchgeführt in mehreren Schritten.
In einem Schritt I. findet ein Bereitstellen von Trainingsdaten TDT umfassend Zustandsgrößen PHC mehrerer Betriebspunkte OPP der Maschine MCH statt. Die Trainingsdaten TDT umfassen mehrere Betriebspunkte OPP und/oder historische Daten und/oder Referenzmessungen und/oder Fingerprints. Anschließend werden in einem Schritt II. Betriebspunkten OPP der Trainingsdaten TDT mittels Clusterings CLS erkannt und zu Betriebspunktclustern OCL zusammengefasst.
In einem Schritt III. wird ein Klassifikator CLF trainiert, die Betriebspunkte OPP zu den erkannten Betriebspunktclustern OCL zuzuordnen. Der Klassifikator CLF arbeitet nach dem Verfahren nearest-centroid oder random-forest.
In einem Schritt IV. werden Anomalieerkennungsmodelle ARM zum Zwecke der Betriebsanomalieerkennung trainiert.

Optional sieht die Erfindung vor, dass den einzelnen Betriebspunktclustern OCL jeweils ein gesondertes Anomalieerkennungsmodell ARM zugeordnet ist, insbesondere, wobei jedem Betriebspunktcluster OCL jeweils ein gesondertes Anomalieerkennungsmodell ARM zugeordnet ist.

Nach der Trainingsphase TPH folgt eine Anwendungsphase APH. Die Anwendungsphase APH beginnt in einem Schritt I. mit dem Aufnehmen von Betriebsdaten OPD umfassend Zustandsgrößen PHC von Betriebspunkten OPP der Maschine MCH in einem bestimmten Betriebszustand. Hierbei erfolgt zunächst in einem Schritt II. ein Zuordnen der Betriebsdaten OPD zu den Betriebspunktclustern OCL mittels des Klassifikators CLF aus der Trainingsphase TPH. Die Betriebsdaten OPD bzw. Betriebspunkte OPP umfassen Messwerte von mindestens einem der Arten Vibration, Temperatur, Drehmoment, Druck, Strom, Spannung, Leistung. Anschließend in einem Schritt III. erkennt das mindestens eine trainierte, bevorzugt Betriebspunktcluster-spezifische Anomalieerkennungsmodell ARM Betriebsanomalien ANM. Das Anomalieerkennungsmodell ARM ist hierbei ein unsupervised model.

In einem Schritt PRP zwischen den Schritten I. und II. sowohl der Trainingsphase TPH als auch der Anwendungsphase APH (optional auch nur eine der beiden Phasen) findet ein Vorverarbeiten der Trainingsdaten TDT und oder Betriebsdaten OPD mittels Datenbereinigung und/oder Datenskalierung, insbesondere unter Verwendung weiterer Datenquellen und/oder Daten aus einem Digitalen Zwilling und/oder Maschinennennwerten statt.

Zur Einstufung einer erkannten Betriebsanomalie ANM berechnet das Anomalieerkennungsmodell ARM einen Anomalie-Kennwert ASC. Dieser Wert beschreibt den Schweregrad der Anomalie. Eine Betriebsanomalie ANM wird erkannt, wenn der Anomalie-Kennwert ASC einen vorbestimmten Schwellwert ATH überschreitet.

In einem Schritt IV. erfolgt je nach Betriebsanomalie ANM ein:
- Anzeigen des Anomalie-Kennwert ASC und/oder mindestens einer auf dem Anomalie-Kennwert ASC basierende Empfehlungen RCM zum Betrieb der Maschine MCH und/oder
- Automatisches Steuern der Maschine MCH mittels eines Steuerbefehls COD, so dass sich der gegenwärtige Betriebspunkt OPP der Maschine MCH ändert.

## Patentansprüche

1. Verfahren (PRC) zum Überwachen des Betriebs einer Maschine (MCH), insbesondere eines Motors (ENG) oder elektrisch angetriebenen Motors (EEG),
**gekennzeichnet, durch** folgende Schritte:
a) Trainingsphase (TPH):
i. Bereitstellen von Trainingsdaten (TDT) umfassend Zustandsgrößen (PHC) mehrerer Betriebspunkte (OPP) der Maschine (MCH),
ii. Erkennen und zusammenfassen von Betriebspunkten (OPP) der Trainingsdaten (TDT) mittels Clusterings (CLS) zu Betriebspunktclustern (OCL),
iii. Trainieren eines Klassifikators (CLF), der Betriebspunkte (OPP) zu den erkannten Betriebspunktclustern (OCL) zuordnet,
iv. Trainieren mindestens eines Anomalieerkennungsmodells (ARM) zur Betriebsanomalieerkennung,
a) Anwendungsphase (APH):
i. Aufnehmen von Betriebsdaten (OPD) umfassend Zustandsgrößen (PHC) von Betriebspunkten (OPP) der Maschine (MCH) in einem Betriebszustand,
ii. Zuordnen der Betriebsdaten (OPD) zu den Betriebspunktclustern (OCL) mittels des Klassifikators (CLF),
iii. Erkennen von Betriebsanomalien mittels des mindestens einen Anomalieerkennungsmodells (ARM).

2. Verfahren (PRC) nach Anspruch 1, wobei das Anomalieerkennungsmodell (ARM) ein unsupervised model ist.

3. Verfahren (PRC) nach Anspruch 1 oder 2, wobei Betriebspunkte (OPP) und Betriebsdaten (OPD) Messwerte von mindestens einem der Arten: Vibration, Temperatur, Drehmoment, Druck, Strom, Spannung, Leistung umfassen.

4. Verfahren (PRC) nach mindestens einem der vorhergehenden Ansprüche, wobei die Trainingsdaten (TDT) mehrere Betriebspunkte (OPP) und/oder historische Daten und/oder Referenzmessungen umfassen.

5. Verfahren (PRC) nach mindestens einem der vorhergehenden Ansprüche, umfassend
- Vorverarbeiten der Trainingsdaten (TDT) und oder Betriebsdaten (OPD) mittels Datenbereinigung und/oder Datenskalierung, insbesondere unter Verwendung weiterer Datenquellen und/oder Daten aus einem Digitalen Zwilling und/oder Maschinennennwerten.

6. Verfahren (PRC) nach mindestens einem der vorhergehenden Ansprüche, wobei das Anomalieerkennungsmodell (ARM) einen Anomalie-Kennwert (ASC) berechnet, dessen Wert den Schweregrad der Anomalie beschreibt, wobei eine Anomalie und/oder ein Anomalie-Typus erkannt wird, wenn der Anomalie-Kennwert (ASC) einen vorbestimmten Schwellwert (ATH) überschreitet.

7. Verfahren (PRC) nach mindestens einem der vorhergehenden Ansprüche, umfassend:
- Anzeigen des Anomalie-Kennwerts (ASC) und/oder auf dem Anomalie-Kennwert (ASC) basierende Empfehlungen (RCM) zum Betrieb der Maschine (MCH) und/oder
- Steuern, insbesondere automatisches Steuern der Maschine (MCH), so dass sich der gegenwärtige Betriebspunkt (OPP) der Maschine (MCH) ändert.

8. Verfahren (PRC) nach mindestens einem der vorhergehenden Ansprüche, wobei der Klassifikator (CLF) als neuronales Netz ausgebildet ist oder nach den Methoden nearest-centroid oder random-forest arbeitet.

9. Verfahren (PRC) nach mindestens einem der vorhergehenden Ansprüche, wobei einzelnen Betriebspunktclustern (OCL) jeweils ein gesondertes Anomalieerkennungsmodell (ARM) zugeordnet ist, insbesondere wobei jedem Betriebspunktcluster (OCL) jeweils ein gesondertes Anomalieerkennungsmodell (ARM) zugeordnet ist.

10. Computerprogrammprodukt zur Durchführung eines Verfahrens nach einem der vorhergehenden Ansprüche mittels mindestens eines Computers (CMP) oder Computer-Netzwerkes.

11. Anordnung, insbesondere umfassend mindestens einen Computer zur Durchführung eines Verfahrens nach einem der vorhergehenden Ansprüche 1 bis 9 mittels mindestens eines Computers (CMP), wobei die Anordnung den mindestens einen zur Durchführung des Verfahrens vorbereiteten Computer (CMP) umfasst.
